# EUROPEAN PATENT APPLICATION

(11) **EP 1 703 553 A2**
(43) Date of publication of application: **20.09.2006**
(21) Application number: 06251390.8
(22) Date of filing: 15.03.2006
(51) Int. Cl.: H01L 21/768

(54) **Via in semiconductor substrate and its fabrication method**

(30) Priority: 18.03.2005 JP 2005079638
(71) Applicant: SHARP KABUSHIKI KAISHA, Osaka-shi, Osaka 545-8522 (JP)
(72) Inventor: Goto, Toshihisa, Hiroshima 721-0906 (JP); Ishihama, Akira, Fukuyama-shi, Hiroshima 720-0836 (JP); Yamazaki, Osamu, Fukuyama-shi, Hiroshima 721-0963 (JP)
(74) Representative: Brown, Kenneth Richard

(57) **Abstract**

A fabrication method of a semiconductor device comprises the steps of forming a metal thin film (18) whose oxide is insulative on the sidewall of a hole formed in a semiconductor substrate and forming an insulating metal oxide film (19) by oxidizing the metal thin film.

## Description

### BACKGROUND OF THE INVENTION

### 1. Field of the Invention

The invention relates to a semiconductor device having a through electrode and a fabrication method of the semiconductor device.

### 2. Description of the Related Art

In these years, along with the tendency of compactness and high performance of electronic appliances represented by computers and communication appliances, it is required for a semiconductor device to be compact and have high density and high speed. Therefore, a semiconductor device so-called three-dimensional chip comprising a plurality of layered semiconductor chips for making the device compact and highly densified has been proposed. For example, Japanese Patent Laid-Open No. HEI 10 (1998)-223833 proposes a method for forming a through electrode in a semiconductor substrate and layering a plurality of chips.

Further, there is proposed a semiconductor device having a semiconductor substrate, the substrate having a through electrode. The semiconductor device is designed to be mounted via the rear face of the through electrode, for the purpose of achieving compactness. As an example of such a device, Japanese Patent Laid-Open No. 2001-351997 proposes a light receiving sensor-installed structural body.

In a fabrication method of a semiconductor device having a through electrode in a silicon substrate as described above, there is an insulating film formation method by electrodeposition as described in Japanese Patent Laid-Open No. 2003-289073 as a method for forming an insulating film on the inner wall of a through hole.

Herein, a fabrication method of a conventional semiconductor device having a through electrode will be described along with Figs. 5A to 5F. Figs. 5A to 5F show cross-sectional view showing the fabrication steps of the semiconductor device.

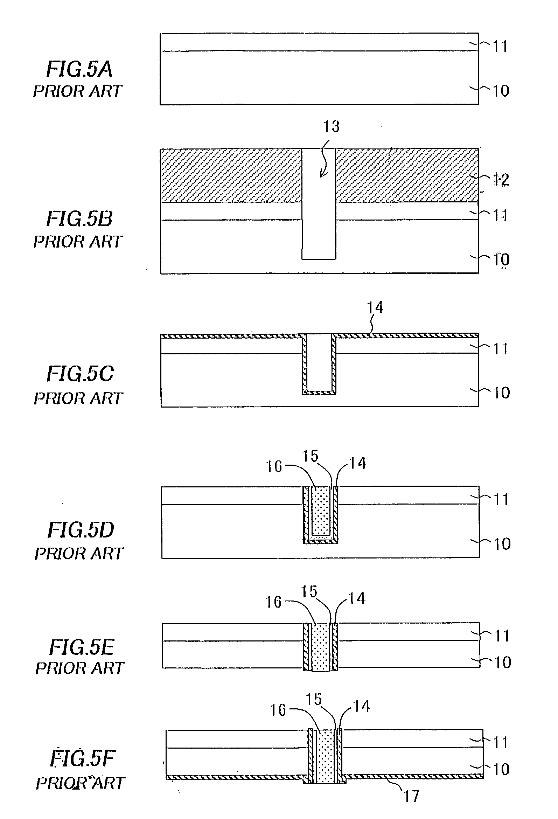

At first, as shown in Fig. 5A, an element formation part 11 is formed on the top face of the semiconductor substrate 10. Next, as shown in Fig. 5B, a photoresist pattern 12 is formed and using the photoresist pattern 12 as a mask, the element formation part 11 and the semiconductor substrate 10 are successively etched by a method of reactive ion etching (RIE) or the like to form a hole 13 with a depth of about 100 µm from the substrate surface.

Next, as shown in Fig. 5C, a silicon oxide film 14 is formed on the element formation part 11 and the sidewall face of the hole 13 by an LPCVD method.

Next, a seed film 15 to be a cathode for electroplating is deposited on the silicon oxide film 14. After that, using the seed film 15 as a cathode, the inside of the hole 13 is filled with Cu 16 by an electroplating method. Further, the Cu 16, the seed film 15, and the silicon oxide film 14 existing outside of the hole 13 are removed by CMP to obtain the structure shown in Fig. 5D.

Next, as shown in Fig. 5E, the rear face of the semiconductor substrate 10 is ground to expose Cu 16 to the rear face.

Next, as shown in Fig. 5F, a rear face insulating film 17 of SiN, SiO₂ or the like is formed on the rear face of the semiconductor substrate 10.

The semiconductor device having a through electrode is obtained by the above-mentioned process.

In the fabrication method of the semiconductor device having the through electrode with the above-mentioned structure, the silicon oxide film is formed on the sidewall part of the hole 13 by an LPCVD method. However if the method is employed, it becomes difficult to lower the treatment temperature. Particularly, under a temperature condition of 100°C or lower, the oxide film quality is inferior and the dielectric strength is lowered. Further, there is a problem that the film formation rate is so low as to take a long time for the film formation and consequently the process cost is adversely increased.

In the case of insulating film formation by electrodeposition, the process can be carried out at a temperature as low as 100°C or lower. In an electrodeposition process, voltage has to be applied to the semiconductor substrate. Because the semiconductor substrate is semiconductive, it is difficult to apply voltage evenly to the substrate. Accordingly, the film thickness becomes uneven and in the worst case, an insulation film is not formed and insulation from the substrate is not secured.

Accordingly, it has been difficult for conventional methods to form a good quality insulating film on the sidewall of a hole by low temperature process of 100°C or lower.

### SUMMARY OF THE INVENTION

In view of the above-mentioned state of the art, the invention aims to provide a fabrication method of a semiconductor device in which a high quality insulating film can be formed on the sidewall of a hole by a low temperature process.

The fabrication method of a semiconductor device of the invention is characterized by comprising steps of forming a metal thin film whose oxide is insulative on the sidewall of a hole formed in a semiconductor substrate and forming an insulating metal oxide film by oxidizing the metal thin film.

According to the invention, at first the metal thin film is formed on the sidewall of the hole and the film is oxidized to form an insulating film on the sidewall of the hole. The metal thin film can be formed evenly even by a low temperature process and oxidation of the metal thin film can be carried out at a low temperature. Therefore, a high quality insulating film can be formed on the sidewall of the hole by a low temperature process, which can prevent heat damage of the semiconductor device at the time of insulating film formation.

### BRIEF DESCRIPTION OF THE DRAWINGS

Fig. 1 is a cross-sectional view shows the structure of the semiconductor device of Example 1 of the invention.
Fig. 2A to Fig. 2G are cross-sectional views showing the fabrication steps of the semiconductor device of Example 1 of the invention.
Fig. 3A to Fig. 3H are cross-sectional views showing the fabrication steps of the semiconductor device of Example 2 of the invention.
Fig. 4A to Fig. 4F are cross-sectional views showing the fabrication steps of the semiconductor device of Example 3 of the invention.
Fig. 5A to Fig. 5F are cross-sectional views showing the fabrication steps of a conventional semiconductor device.

### DESCRIPTION OF THE PREFERRED EMBODIMENTS

### (First Embodiment)

A fabrication method of a semiconductor device of the first embodiment of the invention is characterized in that the method involves steps of forming a metal thin film whose oxide is insulative on the sidewall of a hole formed in a semiconductor substrate and forming an insulating metal oxide film by oxidizing the metal thin film.

The type of the semiconductor substrate is not limited and examples of the substrate include a Si substrate, a Galis substrate and the like. It is preferable to previously form an element formation part on the semiconductor substrate. The element formation part is comprised of a semiconductor element such as a transistor, a diode, a resistor, a capacitor, an inductor or the like, and a wiring connecting semiconductor elements. Formation method of the element formation part is not limited and can be formed by ordinary semiconductor manufacturing processes.

The hole may be a through hole or a non-through hole. The cross-sectional shape of the hole may be circular, polygonal, groove-like shape or the like, and the shape may be properly determined in accordance with the use of the like. The hole can be formed by a photolithography and etching technique, for example. The shape, depth, size, and formation method of the hole are not limited.

The material for the metal thin film is not limited as long as the material is a metal whose oxide is insulative. The material may preferably be aluminum or tantalum. It is because if either of aluminum or tantalum is used, a dense insulating film having a high dielectric strength can be obtained by oxidation. Formation method of the metal thin film is not limited, but the metal thin film is preferably formed by a sputtering method. It is because a good quality metal thin film can be formed at a low temperature by a sputtering method.

Oxidation method of the metal thin film is not limited, but the metal thin film is preferably oxidized by an anodization method, thereby oxidation at a low temperature is made possible.

After the above-mentioned step, a step of filling the inside of the hole with a conductive material may further be added. Filled conductive material is exposed to the front face and the rear face of the substrate to form the through, electrode. The type of the conductive material to be filled is not limited, and the conductive material is, for example, cupper. The filling method is not limited, and, for example, an electroplating method.

Further, in the case where a non-through hole is formed in a substrate, a step of grinding the rear face of the semiconductor substrate to expose the filled conductive material to the rear face may further be added. Exposure of the filled conductive material to the rear face makes it possible to form the through electrode.

### (Second embodiment)

A fabrication method of a semiconductor device of the second embodiment of the invention is characterized in that the method involves steps of forming a metal thin film whose oxide is insulative on the sidewall of a hole formed in a semiconductor substrate and on the front face of the substrate; covering a portion of the metal thin film on the front face of the substrate with an oxidation prevention arid forming an insulating metal oxide film by oxidizing the exposed metal thin film portion.

Although the second embodiment is similar to the first embodiment, this embodiment diners from the first embodiment mainly in a point that the method involves a step of covering a portion of the metal thin film on the front face of the substrate with an oxidation prevention film. Hereinafter the different point from the first embodiment will be described.

Since the portion covered with the oxidation prevention film is not oxidized, the conductivity is not substantially changed even after the oxidation step. Accordingly, this portion can be used as wiring. The type of the oxidation prevention film is not limited as long as the oxidation prevention film has a function of preventing oxidation. The oxidation prevention film is, for example, comprised of a photoresist pattern, and the formation method, thickness, composition, and structure (monolayer or multilayer) are not limited.

### (Third embodiment)

A fabrication method of a semiconductor device of the third embodiment of the invention is characterized in that the method involves steps of forming a metal thin film whose oxide is insulative on the sidewall of a through hole formed in a semiconductor substrate and on the rear face of the substrate and forming an insulating metal oxide film by oxidizing the metal thin film.

Although the third embodiment is similar to the first embodiment, this embodiment differs from the first embodiment mainly in points that the hole is a through hole and that the metal thin film is formed on the rear face of the substrate with an oxidation prevention film. Hereinafter, the different points from the first embodiment will be described.

In this embodiment, since the metal thin film is formed on the sidewall of the through hole and the rear face of the substrate and oxidized, the insulating film on the sidewall and the insulating film on the rear face can simultaneously be formed.

### (Fourth embodiment)

A semiconductor device of the fourth embodiment of the invention is characterized in that a through hole is formed in a semiconductor substrate and a metal oxide film which is insulative is formed on the sidewall of the through hole and the inside of the through hole is filled with a conductive material.

The semiconductor device can be fabricated by any one of the first to the third embodiments. Accordingly, the semiconductor device of this embodiment has an even insulating film on the sidewall and can be fabricated at a high yield.

Hereinafter, a fabrication method of a semiconductor device of the invention will be described in detail with reference to Examples. The shapes, structures, thicknesses, compositions, methods or the like described hereinbelow or in the drawings are given for the purpose of illustration only, and the scope of the invention is not limited to that described below or shown in the drawings.

### 1. Example 1

### 1-1. Structure of Semiconductor Device

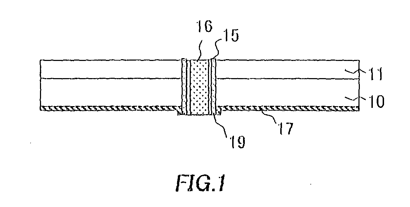

Fig. 1 is a cross-sectional view showing the structure of a semiconductor device of this Example. In the semiconductor device of this Example, an elemellt formation par 11 is formed on a semiconductor substrate 10 of a silicon wafer: a through hole penetrating the part 11 and the substrate 10 is formed: an insulating metal oxide film 19 is formed on the sidewall of the through hole: and the inside of the trough hole is filled with a conduclive material 16 of a metal via a seed film 15. A rear face insulating film 17 is formed on the rear face of the semiconductor substrate 10.

### 1-2. Fabrication Method of Semiconductor Device

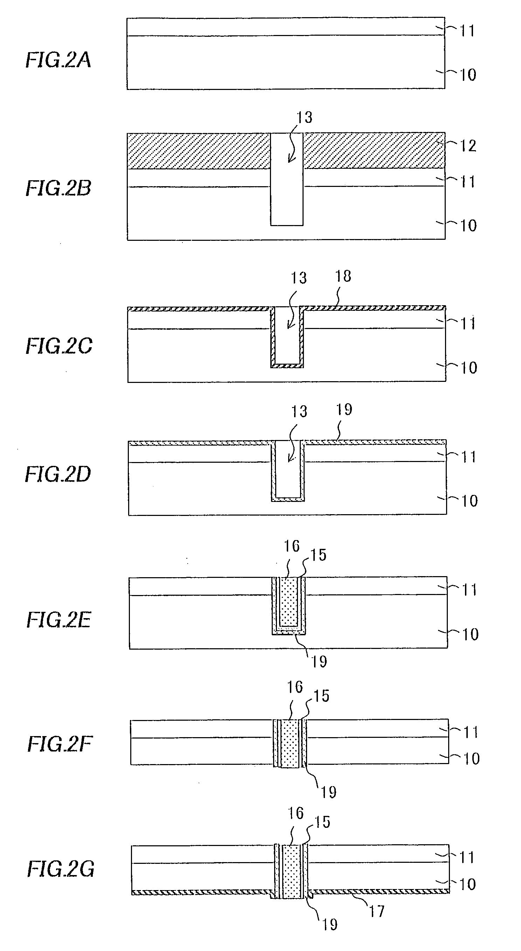

Hereinafter, a fabrication method of the semiconductor device will be described along with Fig. 2A to Fig. 2G. Fig. 2A to Fig. 2G are cross-sectional views showing the fabrication steps of the semiconductor device of this Example.

### (1) Step for Forming Element Formation Part and Hole

At first, as shown in Fig. 2A, the element formation part 11 is formed on the surface of the semiconductor substrate 10. Next, as shown in Fig. 2B, a photoresist pattern 12 is formed and using the photoresist pattern 12 as a mask, the element formation part 11 and the semiconductor substrate 10 are successively etched by a method of reactive ion etching (RIE) or the like to form a hole 13 with a depth of about 100 µm from the substrate surface. The conditions in this case may be as follows: the silicon oxide film of the element formation part 11 is etched with a CF₄/O₂ based gas and the semiconductor substrate 10 of silicon is etched with SF₆/O₂ based gas. The etching temperature is controlled to be 100°C or lower. Although the hole 13 is made to be a non-through hole in this Example, it may be a through hole.

### (2) Step for Forming Aluminum Thin Film

Next, as shown in Fig. 2C, an aluminum thin film 18 with a thickness of 200 to 10000Å is formed on the element formation part 11 and the sidewall face of the hole 13 by a sputtering method. Concrete film formation conditions in this Example are, for example, as a temperature is 100°C or lower; applied voltage is 3 kW; an argon gas flow rate is 50 SCCM; and a pressure is 0.4 Pa.

### (3) Step for Oxidizing Aluminum Thin Film

Next, as shown in Fig. 2D, an anodized film 19 is formed on the element formation part 11 and the sidewall face of the hole 13 by an anodization method. The anodization method is carried out by connecting one end of the aluminum thin film 18 with a positive pole of a d.c. power source and immersing the sample in a 3% ammonium phosphate solution. The temperature in this case is adjusted to be a room temperature (about 10 to 30°C). A carbon rod is connected in the negative pole of the d.c. power source and immersed in the same solution at a distance of about 5 cm from the aluminum thin film sample. The anodized film formation is carried out by applying a voltage of 5 to 50V. The aluminum thin film 18 is gradually oxidized from the vicinity of the surface and voltage is continuously applied until the oxidation reaction is completely promoted. The aimed film thickness is about 200 to 10000Å.

### (4) Step for Filling Hole with Cu

Next, the seed film 15 to be a cathode for electroplating is deposited on the anodized film 19. Using the film as a cathode, the inside of the hole 13 is filled with Cu 16 by an electroplating method. Further, Cu 16, the seed film 15, and the anodized film 19 deposited on portions other than the hole 13 are removed by CMP to obtain the structure shown in Fig. 2E.

### (5) Step for Grinding Rear Face and Forming Rear Face Insulating Film

Next, as shown in Fig. 2F, the rear face of the semiconductor substrate 10 is ground to expose Cu 16 to the rear face.

Next, as shown in Fig. 2G, a rear face insulating film 17 of SiN, SiO₂ or the like is formed on the rear face of the semiconductor substrate 10.

According to the fabrication method of the semiconductor device of this Example, since the sidewall insulating film in the hole can be formed at a room temperature, heat damage on the element can be suppressed.

### 2. Example 2

### 2-1. Fabrication Method of Semiconductor Device

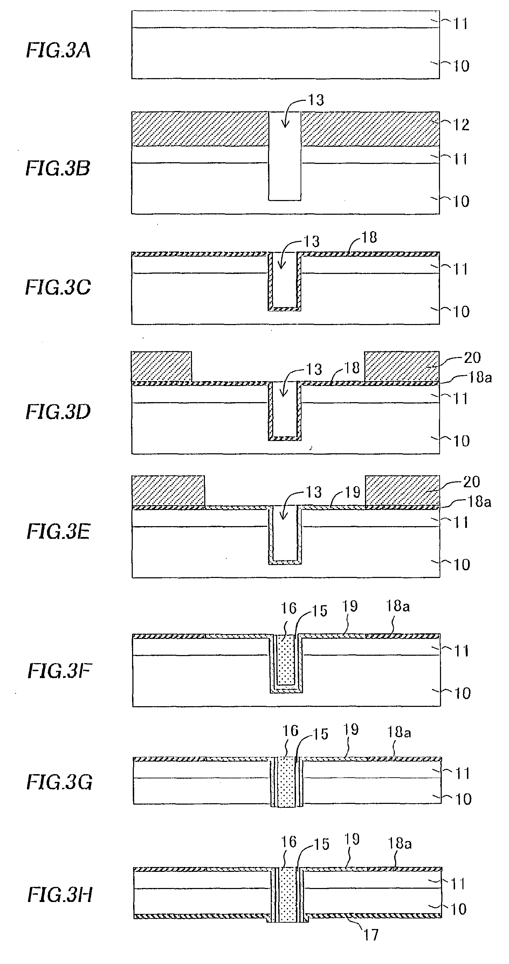

Hereinafter, a fabrication method of the semiconductor device will be described along with Fig. 3A to Fig. 31-1. Fig. 3A to Fig. 3H are cross-sectional views showing the fabrication steps of the semiconductor device of this Example.

### (1) Step for Forming Element Formation Part and Hole

At first, as shown in Fig. 3A, the element formation part 11 is formed on the surface of the semiconductor substrate 10. Next, as shown in Fig. 3B, a photoresist pattern 12 is formed and using the photoresist pattern 12 as a mask, the element formation part 11 and the semiconductor substrate 10 are successively etched by a method of reactive ion etching (RIE) or the like to form a hole 13 with a depth of about 100 µm from the substrate surface. The conditions in this case may be as follows: the silicon oxide film of the element formation part 11 is etched with a CF₄/O₂ based gas and silicon of the semiconductor substrate 10 is etched with SF₆/O₂ based gas. The etching temperature is controlled to be 100°C or lower.

### (2) Step for Forming Aluminum Thin Film

Next, as shown in Fig. 3C, an aluminum thin film 18 with a thickness of 200 to 10000Å is formed on the element formation part 11 and the sidewall face of the hole 13 by a sputtering method. Concrete film formation conditions in this Example are, for example, as a temperature is 100°C or lower; applied voltage is 3 kW; an argon gas flow rate is 50 SCCM; and a pressure is 0.4 Pa.

### (3) Step for Forming Photoresist Pattern

Next, as shown in Fig. 3D, a photoresist pattern 20 is formed on a region to be used as wiring in the aluminum thin film.

### (4) Step for Oxidizing Aluminum Thin Film

Next, as shown in Fig. 3E, an anodized film 19 is formed on the other region which is not covered with the photoresist pattern in the aluminum thin film 18 and the sidewall face of the hole 13 by an anodization method. The anodization method is carried out by connecting one end of the aluminum thin film 18 with a positive pole of a d.c. power source and immersing the sample in a 3% ammonium phosphate solution. The temperature in this case is adjusted to be a room temperature (about 10 to 30°C). A carbon rod is connected in the negative pole of the d.c. power source and immersed in the same solution at a distance of about 5 cm from the aluminum thin film sample. The anodized film formation is carried out by applying a voltage of 5 to 50V. The aluminum thin film 18 is gradually oxidized from the vicinity of the surface and voltage is continuously applied until the oxidation reaction is completely promoted. At that time, since the region 18a of the aluminum thin film 18 covered with the photoresist pattern 20 is not immersed with the solution, the region is not anodized.

### (5) Step for Hole with Cu

Next, the photoresist pattern 20 is removed and the seed film 15 to be a cathode for electroplating is deposited on the anodized film 19. Using the film as a cathode, the inside of the hole 13 is filled with Cu 16 by an electroplating method. Further, Cu 16, the seed film 15, and the anodized film 19 deposited on portions other than the hole 13 are removed by CMP to obtain the structure shown in Fig. 3F.

### (6) Step for Grinding Rear Face and Forming Rear Face Insulating Film

Next, as shown in Fig. 3G, the rear face of the semiconductor substrate 10 is ground to expose Cu 16 to the rear face. Next, as shown in Fig. 3H, a rear face insulating film 17 of SiN, SiO₂ or the like is formed on the rear face of the semiconductor substrate 10.

According to the fabrication method of the semiconductor device of this Example, an additional wiring pattern can be formed simultaneously.

### 3. Example 3

### 3-1. Fabrication Method of Semiconductor Device

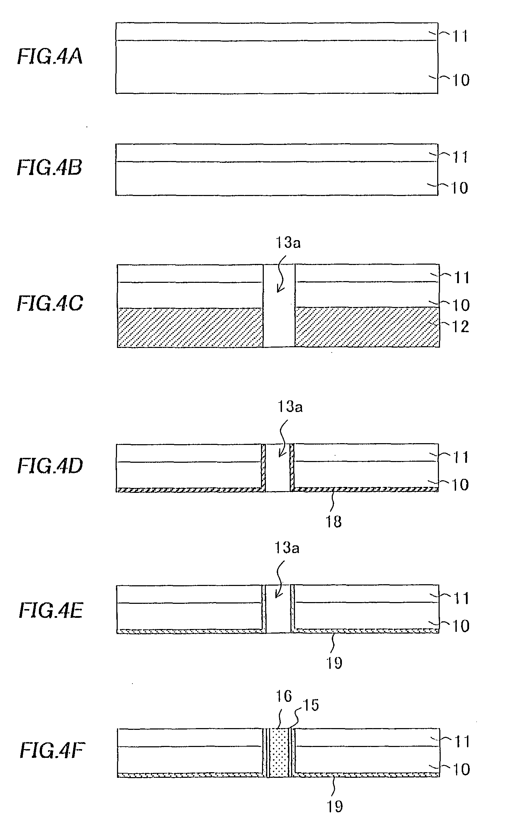

Hereinafter, a fabrication method of the semiconductor device will be described along with Fig. 4A to Fig. 4F. Fig. 4A to Fig. 4F are cross-sectional views showing the fabrication steps of the semiconductor device of this Example.

### (1) Step for Forming Element Formation Part and Thinning Semiconductor Substrate

At first, as shown in Fig. 4A, the element formation part 11 is formed on the surface of the semiconductor substrate 10. Next, as shown in Fig. 4B, the rear face of the semiconductor substrate 10 is recessed. Recessirig the rear face of the semiconductor substrate 10 is carried out by a processing technique, for example, mechanical grinding, chemical polishing, plasma etching, or gas etching. The treatment conditions are as follows: in the case of the mechanical grinding, rough grinding is carried out using around #300 grinding stone and after the grinding, finishing grinding is carried out using around #2000 grinding stone. The thickness of the semiconductor substrate 10 after the recessing is preferably 100 µm or thinner, more preferably 30 to 50 µm, to make the thickness for disposition as thin as possible.

Along with the thinning of the semiconductor substrate 10, if necessary, a reinforcing plate may be stuck to the element formation part of the semiconductor substrate 10 for reinforcement.

### (2) Step for Forming Through Hole

Next, as shown in Fig. 4C, a photoresist pattern 12 is formed on the rear face of the semiconductor substrate 10 and using the photoresist pattern 12 as a mask, the element formation part 11 and the semiconductor substrate 10 are successively etched by a method of reactive ion etching (RIE) or the like to form a through hole 13a. The conditions in this case may be as follows: silicon of the semiconductor substrate 10 is etched with SF₆/O₂ based gas and the silicon oxide film of the element formation part 11 is etched with a CF₄/O₂ based gas. The etching temperature is controlled to be 100°C or lower.

### (3) Step for Forming Aluminum Thin Film

Next, as shown in Fig. 4D, an aluminum thin film 18 with a thickness of 200 to 10000Å is formed on the rear face of the semiconductor substrate 10 and the sidewall face of the through hole 13a by a sputtering method. Concrete film formation conditions in this Example are, for example, as a temperature is 100°C or lower; applied voltage is 3 kW; an argon gas flow rate is 50 SCCM; and a pressure is 0.4 Pa.

### (4) Step for Oxidizing Aluminum Thin Film

Next, as shown in Fig. 4E, an anodized film 19 is formed on the rear face of the semiconductor substrate 10 and the sidewall face of the through hole 13a by an anodization method. The anodization method is carried out by connecting one end of the aluminum thin film 18 with a positive pole of a d.c. power source and immersing the sample in a 3% ammonium phosphate solution. The temperature in this case is adjusted to be 10 to 30°C. A carbon rod is connected in the negative pole of the d.c. power source and immersed in the same solution at a distance of about 5 cm from the aluminum thin film sample. The anodized film formation is carried out by applying a voltage of 5 to 50V. The aluminum thin film 18 is gradually oxidized from the vicinity of the surface and voltage is continuously applied until the oxidation reaction is completed.

### (5) Step for Filling Through Hole with Cu

Next, the seed film 15 to be a cathode for electroplating is deposited on the anodized film 19. Using the film as a cathode, the inside of the through hole 13a is filled with Cu 16 by an electroplating method. Further, Cu 16 and the seed film 15 deposited on portions other than the through hole 13a are removed by CMP to obtain the structure shown in Fig. 4F. At that time, the anodized film 19 formed on the rear face of the semiconductor substrate 10 is left without being removed.

According to the fabrication method of the semiconductor device of this Example, the insulating film in the through hole sidewall can be formed simultaneously with the formation of the rear face insulating film and therefore the process can be simplified.

The invention thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A fabrication method of a semiconductor device comprises the steps of:
forming a metal thin film whose oxide is insulative on the sidewall of a hole formed in a semiconductor substrate; and
forming an insulating metal oxide film by oxidizing the metal thin film.

2. A fabrication method of a semiconductor device comprises the steps of:
forming a metal thin film whose oxide is insulative on the sidewall of a hole formed in a semiconductor substrate and on the front: face of the substrate;
covering a portion of the metal thin film on the front face of the substrate with an oxidation prevention film; and
forming an insulating metal oxide film by oxidizing the exposed metal thin film portion.

3. A fabrication method of a semiconductor device comprises the steps of:
forming a metal thin film whose oxide is insulative on the sidewall of a through hole formed in a semiconductor substrate and on the rear face of the substrate; and
forming an insulating metal oxide film by oxidizing the metal thin film.

4. The method of any one of claims 1 to 3, wherein the metal thin film is formed by a sputtering method.

5. The method of any one of claims 1 to 3, wherein the metal thin film is made of aluminum or tantalum.

6. The method of any one of claims 1 to 3, wherein the oxidization of the metal thin film is conducted by an electroplating method.

7. The method of claim 1 or 2, further comprising the step of filling the inside of the hole with a conductive material.

8. The method of claim 3, further comprising the step of filling the inside of the through hole with a conductive material.

9. The method of claim 7, wherein the hole is a non-through hole, and further comprising the step of grinding the rear face of the semiconductor substrate to expose the filled conductive material to the rear face.

10. The method of any one of claims 1 to 3, wherein the semiconductor substrate has an element formation part thereon.

11. The method of claim 1 or 2, wherein the hole is a through hole or a non-through hole.

12. The method of claim 2, wherein the oxidation prevention film is comprised of a photoresist pattern.

13. A semiconductor device comprising:
a semiconductor substrate;
a through hole formed in the semiconductor substrate;
a metal oxide film which is insulative formed on the sidewall of the through hole; and
a conductive material with which the inside of the through hole is filled.

14. The device of claim 13, wherein the metal oxide film is made of an oxide of aluminum or tantalum
